# EUROPEAN PATENT APPLICATION

(11) **EP 4 648 216 A1**
(43) Date of publication of application: **12.11.2025**
(21) Application number: 24738688.1
(22) Date of filing: 03.01.2024
(51) Int. Cl.: H01Q 1/02, H04B 7/0413, H01Q 1/38, H05K 7/20

(54) **MULTI-INPUT AND MULTI-OUTPUT ANTENNA APPARATUS**

(30) Priority: 04.01.2023 KR 20230001344; 02.01.2024 KR 20240000243
(71) Applicant: KMW Inc., Hwaseong-si, Gyeonggi-do 18462 (KR)
(72) Inventor: JEONG, Bae Mook, Suwon-si Gyeonggi-do 16545 (KR); AHN, Seong Min, Namyangju-si Gyeonggi-do 12109 (KR); LEE, Seung Min, Goyang-si Gyeonggi-do 10530 (KR); KIM, Jae Eun, Suwon-si Gyeonggi-do 16330 (KR)
(74) Representative: Impuls legal PartG mbB
(86) International application number: PCT/KR2024/000077
(87) International publication number: WO 2024/147617

(57) **Abstract**

Provided is a massive multi-input and multi-output antenna apparatus. The massive multi-input and multi-output antenna apparatus includes a main board stacked so that a back surface of the main board is in close contact with an inner surface of a heat dissipation housing, a sub board stacked to be in close contact with a front or back surface of the main board, a first heat generating element mounted only on the main board and mounted only on the back surface of the main board, which is a side provided with a plurality of heat dissipation fins, and a second heat generating element mounted only on the sub board and mounted only on a back surface of the sub board, which is a side provided with the plurality of heat dissipation fins, thereby preventing an increase in the product manufacturing cost through the automation and simplification of a product manufacturing process.

## Description

### [Technical Field]

The present disclosure relates to a massive multi-input and multi-output antenna apparatus, and more specifically, to a massive multi-input and multi-output antenna apparatus that allows a heat generating element being an RF element to be directly mounted on a back surface of a sub-board and can reduce the overall product manufacturing cost by reducing a separate processing process for heat dissipation.

### [Background Art]

A wireless communication technology, for example, a multi-input multi-output (MIMO) technology, is a technology of dramatically increasing a data transmission capacity by using a plurality of antennas, and is a spatial multiplexing technique in which a transmitter transmits different data through respective transmission antennas and a receiver distinguishes transmission data through appropriate signal processing.

Accordingly, by simultaneously increasing the number of transmission antennas and the number of reception antennas, a channel capacity is increased, so that more data can be transmitted. For example, when the number of antennas is increased to 10, a channel capacity is secured about 10 times by using the same frequency band as compared to the current single antenna system. In the case of a transmission/reception apparatus adopting such a MIMO technology, as the number of antennas is increased, the number of transmitters and the number of filters are also increased.

In particular, in a main housing, a plurality of substrates (for example, a printed board assembly (PBA) closely arranged on a back surface side on an installation space of the main housing, an antenna board stacked to be spaced apart by a predetermined distance toward the front side of the PBA, a PSU substrate arranged on one side of the PBA or the antenna board, and the like) are stacked, and a plurality of RF power supply network elements and RF filters that generate a large amount of driving heat during operation are installed.

However, a massive multi-input and multi-output antenna apparatus in the related art is required to effectively discharge a large amount of driving heat generated in a main housing during operation to the outside (in particular, the rear) of the main housing. To this end, the massive multi-input and multi-output antenna apparatus adopts a structure in which a heat generating element is mounted on a front surface of a PBA, and then a plurality of via holes are processed through the rear of the PBA, which is a mounting surface of the heat generating element, or heat transfer coins are installed at positions corresponding to the plurality of via holes, thereby dissipating heat.

However, since the PBA is generally made of a substrate material with low thermal conductivity, the structure of discharging heat through the via hole has low heat dissipation efficiency due to a small contact area between the heat generating element and the via hole. In addition, the heat dissipation structure using the heat transfer coin also has a problem in that it exhibits a reduced heat dissipation effect due to a contact tolerance of a contact surface with the heat generating element.

### [Disclosure]

### [Technical Problem]

The present disclosure is directed to providing a massive multi-input and multi-output antenna apparatus that allows a heat generating element being an RF element to be directly mounted on a back surface of a sub-board and can reduce the overall product manufacturing cost by reducing a separate processing process for heat dissipation.

Technical problems of the present disclosure are not limited to the above-described problems, and other problems that are not mentioned will be able to be clearly understood by those skilled in the art from the following description.

### [Technical Solution]

In order to achieve the objects, a massive multi-input and multi-output antenna apparatus according to an embodiment of the present disclosure includes: a main board stacked so that a back surface of the main board is in close contact with an inner surface of a heat dissipation housing; a sub board stacked to be in close contact with a front or back surface of the main board; a first heat generating element mounted only on the back surface of both surfaces of the main board, the back surface being in contact with the inner surface of the heat dissipation housing; and a second heat generating element mounted only on a back surface of both surfaces of the sub-board, the back surface being in contact with the inner surface of the heat dissipation housing.

The first heat generating element and the second heat generating element may be connected to corresponding points formed on the back surfaces of the main board and the sub-board by a brazing method using solder paste applied in advance to surfaces to be mutually joined.

In addition, the main board may be an integrated single board in which multi-layers stacked in a front and rear direction are integrally joined, and the sub-board may be a double-sided PCB.

In addition, the first heat generating element may be employed as a digital element capable of controlling a plurality of digital signals by being connected to a plurality of signal contact points implemented through the multi-layers of the main board.

In addition, the second heat generating element may be employed as an analog element that maintains RF characteristics by a dielectric constant of the double-sided PCB on which dielectric layers having different dielectric constants from the multi-layer of the main board are applied on both surfaces.

In addition, the first heat generating element may be a digital element, an electrical signal connection surface (hereinafter, abbreviated as 'signal connection surface') provided with a plurality of signal connection points and a heat dissipation surface where operating heat is concentrated and dissipated may be separated, the signal connection surface may be formed on the front surface mounted in close contact with the back surface of the main board, and the heat dissipation surface may be formed on the back surface opposite to the front surface.

In addition, the second heat generating element may be an analog element, an electrical signal connection surface (hereinafter, abbreviated as 'signal connection surface') provided with a plurality of signal connection points and a heat dissipation surface where operating heat is concentrated and dissipated may be separated, the signal connection surface may be formed on the front surface mounted in close contact with the back surface of the sub-board, and the heat dissipation surface may be formed on the back surface opposite to the front surface.

In addition, corresponding points formed on the main board and the sub-board may be formed at positions corresponding to the plurality of signal connection points of the first heat generating element or the second heat generating element.

In addition, when the sub-board is arranged on the front surface of the main board, a heat dissipation through hole that penetrates forward and backward may be formed in the main board at a portion corresponding to a portion of the sub-board where the second heat generating element is mounted.

In addition, when a surface with which the back surface of the main board is in close contact is assumed as a reference plane, the heat dissipation housing may be formed with: a heat dissipation groove formed by recessing backward based on the reference plane to receive the first heat generating element and the second heat generating element mounted on the back surface of the sub-board stacked on the back surface of the main board, the heat dissipation groove being in surface thermal contact with the back surfaces of the first heat generating element and the second heat generating element; and a heat dissipation protrusion protruding forward through the heat dissipation through hole based on the reference plane so that the back surface of the second heat generating element mounted on the back surface of the sub-board stacked on the front surface of the main board is in surface thermal contact.

In addition, a heat dissipation interface material may be interposed between the back surface of the first heat generating element or the second heat generating element and a front surface of the heat dissipation groove or the heat dissipation protrusion.

In addition, the heat dissipation interface material may include at least one of thermal grease, a graphite sheet, a heat pipe, a heat spreader, and a vapor chamber.

In addition, the massive multi-input and multi-output antenna apparatus may further include an elastic pressing part that elastically presses the sub-board toward the main board.

### [Advantageous Effects]

A massive multi-input and multi-output antenna apparatus according to an embodiment of the present disclosure can achieve the following various effects.

First, it has the effect of simplifying a product manufacturing process because a second heat generating element being an RF element can be directly mounted on a back surface of a sub-board and thus a separate heat transfer bridge hole for heat dissipation is not required to be processed.

Second, it has the effect of preventing an increase in the overall product manufacturing cost because a method of stacking a sub-board on a main board and a method of mounting a second heat generating element on the sub-board through a signal connection surface can be replaced with an automated process.

### [Description of Drawings]

FIG. 1 is a perspective view for explaining an embodiment of a massive multi-input and multi-output antenna apparatus according to the present disclosure.
FIG. 2 is an exploded perspective view of FIG. 1.
FIG. 3 is a front view and a rear view of a main board and a sub-board implemented as a first embodiment of the present disclosure.
FIG. 4 is a front and back perspective view illustrating a first heat generating element and a second heat generating element mounted on the main board or the sub-board of FIG. 3.
FIG. 5 is a front exploded view and a back exploded view of a part of FIG. 3.
FIG. 6 is a cross-sectional view taken along line A-A in FIG. 5.
FIG. 7 is a front view and a rear view of a main board and a sub-board implemented as a second embodiment of the present disclosure.
FIG. 8 is a front exploded view and a back exploded view of a part of FIG. 7.
FIG. 9 is a cross-sectional view taken along line B-B in FIG. 8.
FIG. 10 is a cross-sectional view illustrating a heat dissipation housing adopting a heat dissipation structure of the second heat generating elements according to the first embodiment and the second embodiment.
FIG. 11a is a cross-sectional view illustrating a signal connection appearance on a main board.
FIG. 11b is a plan perspective view of FIG. 11a.
FIG. 11c is a combination view of a cross-sectional view and a plan view illustrating a mutual interface of FIG. 11a.
FIGS. 12a to 12c are conceptual views illustrating an electrical connection structure of a sub-board to a main board using a clamshell.
FIG. 13 is a three-sided view illustrating the clamshell of FIGS. 12a to 12c.
FIGS. 14 and 15 are conceptual views illustrating embodiments of an electrical connection structure of a sub-board to a main board using an elastic pressing part.
FIGS. 16a to 16d are cross-sectional views illustrating an actual substrate stack structure of an electrical connection structure according to various modified examples of FIGS. 12a to 12c and FIGS. 13 to 15 in a massive multi-input and multi-output antenna apparatus according to an embodiment of the present disclosure.

### <Description of reference numerals>

1: Massive multi-input and multi-output antenna apparatus 10: Heat dissipation housing
11: Heat dissipation fin 13: Heat dissipation groove
15: Heat dissipation protrusion 20: Heat dissipation interface material
110: Main board 113: Heat dissipation through hole
115: First heat generating element 150: Sub-board
155: Second heat generating element 155a: Signal connection surface
155a': Signal connection point 155b: Heat dissipation surface
160: Elastic pressing part 161: Support pad
163: Elastic means 165: Elastic rib

### [Mode for Invention]

Hereinafter, a massive multi-input and multi-output antenna apparatus according to an embodiment of the present disclosure is described in detail with reference to the accompanying drawings.

It is to be noted that in assigning reference numerals to elements in the drawings, the same reference numerals denote the same elements throughout the drawings even in cases where the elements are illustrated in different drawings. Furthermore, in describing the embodiments of the present disclosure, a detailed description of the known configurations or functions will be omitted if it is deemed to obscure the understanding for the embodiments of the present disclosure.

In describing the elements of the embodiments of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as the terms generally understood by those skilled in the art to which the present disclosure pertains. The terms, such as terms defined in dictionaries, which are generally used, should be interpreted as having meanings identical to contextual meanings of the related art, and are not interpreted as having ideal or excessively formal meanings unless they are definitely defined in the present disclosure.

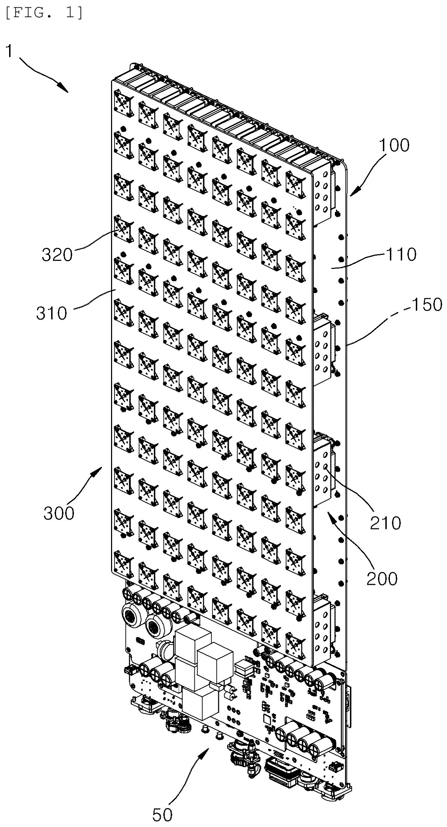

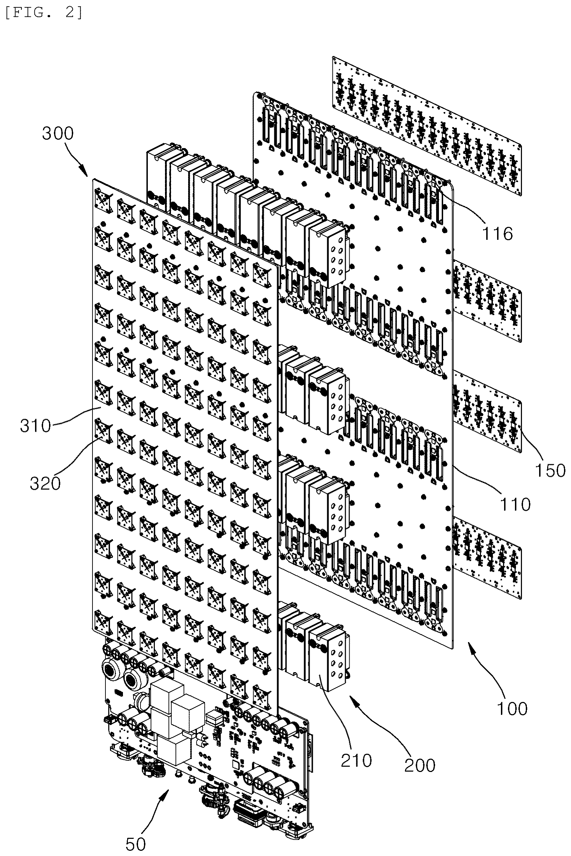

FIG. 1 is a perspective view for explaining an embodiment of a massive multi-input and multi-output antenna apparatus according to the present disclosure, and FIG. 2 is an exploded perspective view of FIG. 1.

An embodiment 1 of a massive multi-input and multi-output antenna apparatus according to the present disclosure includes a first stack assembly 100 that is primarily stacked inside a mounting space of a heat dissipation housing (not illustrated) that is formed in a rectangular parallelepiped shape that forms a mounting space opened forward (upper side of FIG. 1) and has a front-rear receiving width that is long and thin approximately in a vertical direction, a second stack assembly 200 that is mounted and fixed on the front surface of the first stack assembly 100, and a third stack assembly 300 that is stacked on the front end of the second stack assembly 200.

In addition, as illustrated in FIGS. 1 and 2, the embodiment 1 of the massive multi-input and multi-output antenna apparatus according to the present disclosure may further include a power supply unit (hereinafter, abbreviated as "PSU") 50 that is arranged at one end (lower end) in the longitudinal direction of the first stack assembly 100 and supplies power to a plurality of RF power supply network components provided in the first to third stack assemblies 100 to 300.

The PSU 50 serves to control the supply of power to the plurality of RF power supply network components provided in the first to third stack assemblies 100 to 300 in order to perform calibration power supply control and frequency filtering.

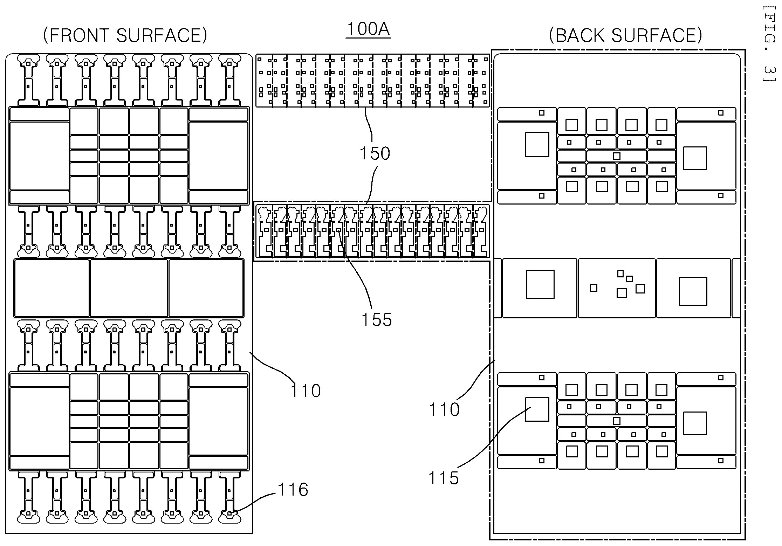

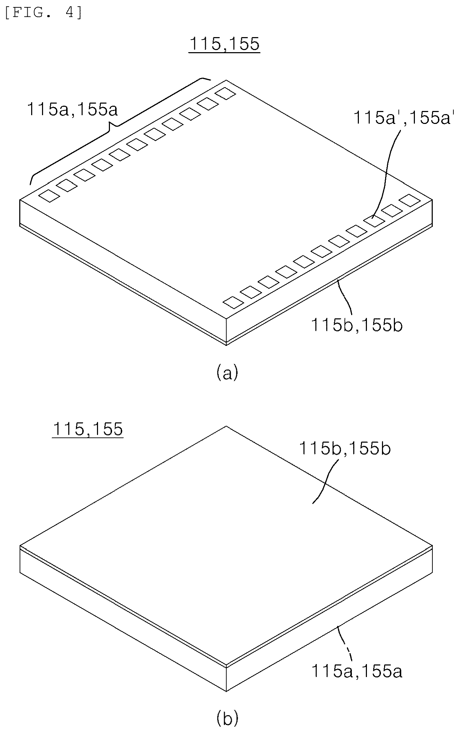

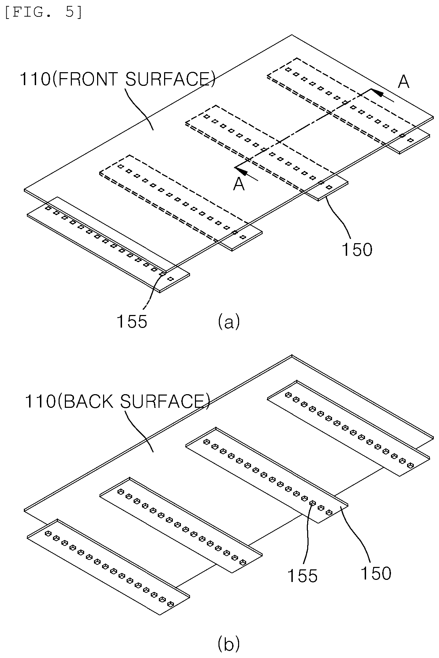

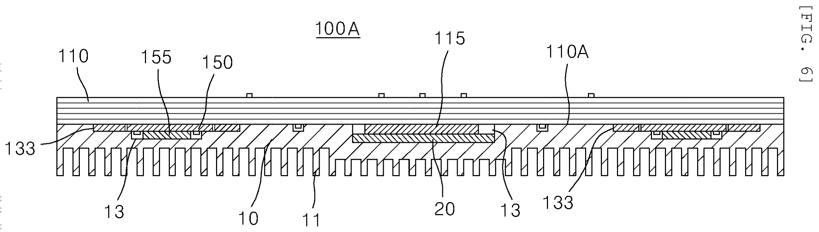

FIG. 3 is a front view and a rear view of a main board and a sub-board implemented as a first embodiment of the present disclosure, FIG. 4 is a front and back perspective view illustrating a first heat generating element and a second heat generating element mounted on the main board or the sub-board of FIG. 3, FIG. 5 is a front exploded view and a back exploded view of a part of FIG. 3, and FIG. 6 is a cross-sectional view taken along line A-A in FIG. 5.

As illustrated in FIGS. 1 and 2, the first stack assembly 100 may include a main board 110 and a sub-board 150.

More specifically, as illustrated in FIGS. 3 to 6, the first stack assembly 100 may include the main board 110 that is stacked so that its back surface is in close contact with an inner surface corresponding to a mounting space of a heat dissipation housing 10, the sub-board 150 that is stacked to be in close contact with a front surface or a back surface of the main board 110, a first heat generating element 115 that is mounted only on the main board 110 of the main board 110 and the sub-board 150 and is mounted only on the back surface of the main board 110, which is a side provided with a plurality of heat dissipation fins on an outer surface of the heat dissipation housing 10, and a second heat generating element 155 that is mounted only on the sub-board 150 of the main board 110 and the sub-board 150 and is mounted only on a back surface of the sub-board 150, which is a side provided with a plurality of heat dissipation fins 11 on the outer surface of the heat dissipation housing 10.

That is, the front and back surface of the main board 110 and the front and back surface of the sub-board 150 may be distributedly mounted with, as the plurality of RF power supply network components as described above, the heat generating elements 115 and 155 that emit a predetermined amount of heat when operated by receiving power.

The main board 110 and the sub-board 150 may each be provided as a FR4 resin-based substrate made of an epoxy resin material. However, the main board 110 and the sub-board 150 do not need to be made of an epoxy resin material, and may be made of different materials depending on the main function of a substrate.

For example, when a heat dissipation function is prioritized, the sub-board 150 may be made of a metal PCB material. When an RF performance maintenance function is prioritized, the sub-board 150 may be provided as a double-sided PCB in which dielectric layers having different dielectric constants from the main board 110 are applied on both surfaces thereof or plated.

The main board 110 may include a plurality of sections having a plurality of transmission/reception channels. The plurality of transmission/reception channels include a transmitter channel and a receiver channel, and the transmitter channel and the receiver channel can be arranged in a pattern to be spaced apart by a predetermined distance in the left-right width direction of the main board 110. The sections having the plurality of transmission/reception channels can be provided in a plural number to be spaced apart by a predetermined distance in the vertical length direction of the main board 110.

Each section is formed with a number of columns corresponding to a number of unit multi-band filters 210 among components of the second stack assembly 200 to be described below, and 16 Tx elements and 16 Rx elements are mounted within the range of one section. By providing four such sections, a massive MIMO technology having a transmission capacity of 64T/64R can be applied.

As illustrated in FIGS. 1 and 2, the second stack assembly 200 may include filters 210 that are arranged between the main board 110 of the first stack assembly 100 and an antenna board 310 of the third stack assembly 300 to perform frequency filtering. The filter 210 can employ any one of a cavity filter, a wave-guide filter, and a dielectric filter. In addition, the filter does not exclude a multi-band filter (MBF) that covers multiplexing frequency bands.

As described above, the filter 210 may be fixed in a plural number to cover an area corresponding to the plurality of sections provided in the main board 110, and may include a pair of transmission channel and reception channel in a corresponding area.

As illustrated in FIGS. 3 to 6, the massive multi-input and multi-output antenna apparatus according to the present disclosure can be implemented as a first embodiment 100A with the following arrangement relationship between the main board 110/the sub-board 150 and the heat generating elements 115 and 155.

That is, an arrangement relationship 1A implemented as the first embodiment 100A can be defined as follows: the main board 110 and the sub-board 150 are stacked so that the front surface of the sub-board 150 is in contact with the back surface of the sub-board 150, and the first heat generating element 115 and the second heat generating element 155 are mounted on the back surfaces of the main board 110 and the sub-board 150, respectively.

The main board 110 has a predetermined thickness, and can be formed as a rectangular thin plate made of an epoxy resin material as described above.

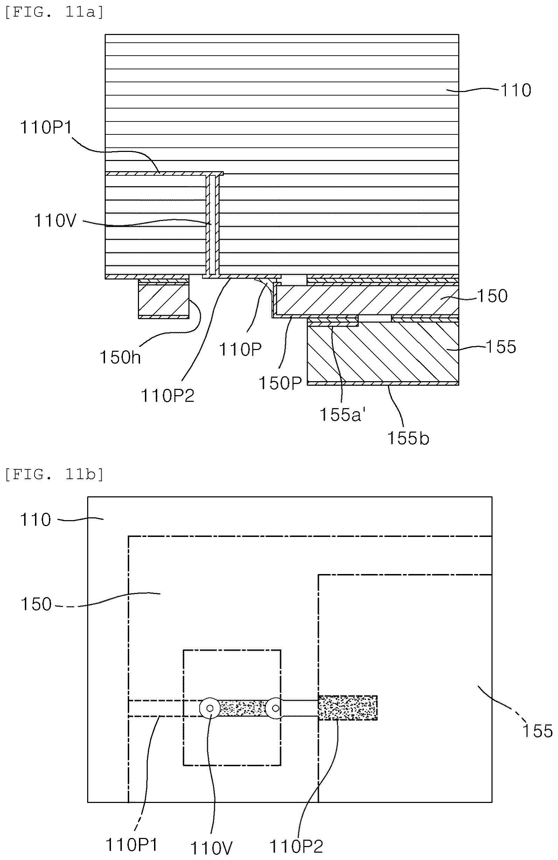

More specifically, the main board 110 may be an integrated single board in which multi-lay7ers stacked in the front and rear direction are integrally joined. A conductive pattern circuit 110P1 or 110P2 can be printed between individual layers constituting the multi-layers of the main board 110, a plurality of via holes 110V can be provided to electrically connect the layers, and the plurality of via holes can be plated with the same conductive material as the conductive pattern circuit to enable electrical connection. The specific electrical connection configuration is described below in more detail with reference to FIG. 11a.

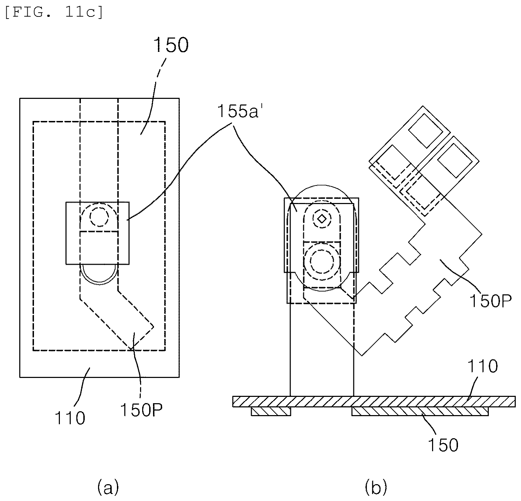

As described above, the sub-board 150 may be a double-sided PCB in which a dielectric layer having a predetermined dielectric constant is applied or joined to both surfaces thereof. The joining interface structure of the sub-board 150 to the main board 110 is described below in more detail with reference to FIG. 11c.

The sub-board 150 may be a functional PCB provided to maintain the RF characteristics of an RF element of the above-described heat generating elements 115 and 155. In general, since the sub-board 150 requires a higher manufacturing cost than the main board 110, it is not preferable in terms of cost to generate the sub-board 150 to have the same area as the entire front or back surface of the main board 110 and stack the sub-board 150. Therefore, the sub-board 150 is preferably formed to have a smaller area than the main board 110 and to have a size for mounting an RF element implemented as the second heat generating element 155.

A plurality of heat generating elements (including the first heat generating element 115) can be mounted on the front and back surfaces of the main board 110. For example, at least one low noise amplifier (LNA) 116, which is an Rx element, can be mounted on the front surface of the main board 110, and digital elements such as a fielded programmable gate array (FPGA) can be mounted on the back surface of the main board 110 as the above-described first heat generating element 115.

That is, the first heat generating element 115 is preferably employed as a digital element capable of controlling a plurality of digital signals by being connected to a plurality of signal contact points implemented through the multi-layer of the main board 110.

The FPGA is mounted on the back surface of the main board 110 as described above, that is, is mounted on the back surface of the main board 110 that is exposed to the rear without overlapping the sub-board 150, so that heat generated by surface thermal contact with the inner surface of the mounting space of the heat dissipation housing 10 can be directly dissipated through the plurality of heat dissipation fins 11 integrally formed on the back surface of the heat dissipation housing 10.

In particular, as illustrated in FIG. 4, the first heat generating element 115 and the second heat generating element 155 to be described below may have different sizes, but an electrical signal connection surface 115a or 155a (hereinafter, abbreviated as 'signal connection surface 115a or 155a') provided with a plurality of signal connection points 115a' or 155a' is separated from a heat dissipation surface 115b or 155b on which operating heat is concentrated and dissipated. The signal connection surface 115a or 155a can be formed on the back surface that is an opposite surface of the front surface that is in close contact with the back surfaces of the main board 110 and the sub-board 150.

In particular, in the case of the second heat generating element 155 provided as an analog element in the past, since it has been difficult to manufacture the signal connection surface 155a and the heat dissipation surface 155b separately, the signal connection surface 155a and the heat dissipation surface 155b have been generally provided on the same surface (surface mounted on the sub-board 150) without being separated.

In this case, it has been difficult to design the sub-board 150 to be arranged on the front surface of the main board 110, and even when the sub-board 150 is arranged on the back surface of the main board 110, it has been difficult to mount the second heat generating element 155 on the back surface of the sub-board 150, which is a portion that is direct contact with the inner surface of the heat dissipation housing 10. This case has a design problem in that at least one heat transfer bridge hole (not illustrated) needs be formed to discharge heat generated from the second heat generating element 155 to the rear.

However, the second heat generating element 155 provided as an analog element can also be manufactured so that the signal connection surface 155a and the heat dissipation surface 155b are opposite to each other (that is, separated), as in the first heat generating element 115 that is a digital element. In this case, the embodiments 100A and 100B of the present disclosure can solve design problems related to the stack structure of the main board 110 and the sub-board 150 and the mounting position of the second heat generating element 155 with respect to the sub-board 150 in the related art.

The above-described arrangement relationship of the massive multi-input and multi-output antenna apparatus 1 according to the present disclosure is implemented in various embodiments (the first embodiment 100A and the second embodiment 100B).

As illustrated in FIGS. 3 to 6, in the arrangement relationship according to the first embodiment 100A, the main board 110 and the sub-board 150 can be stacked so that the front surface of the sub-board 150 faces the back surface of the main board 110, the first heat generating element 115 and the second heat generating element 155 are provided on the back surface of the main board 110 or the sub-board 150, and the signal connection surface 115a or 155a can be provided on the front of each heat generating element and the heat dissipation surface 115b or 155b can be provided on the back of each heat generating element.

In this case, the plurality of signal connection points 115a' or 155a' formed on the signal connection surface 115a or 155a can be connected to corresponding points formed on the back surface of the main board 110 and the back surface of the sub-board 150 by a brazing method using solder paste applied in advance to surfaces to be mutually joined, and can perform heat dissipation by directly surface thermal contacting with the heat dissipation housing 10 through the heat dissipation surface 115b or 155b.

Therefore, the corresponding points formed on the main board 110 and the sub-board 150 can be formed at positions corresponding to the plurality of signal connection points 115a' or 155a' of the first heat generating element 115 or the second heat generating element 155.

The heat dissipation housing 10 can be formed on the inner surface thereof with a sub-board receiving groove 133 for receiving the sub-board 150 and heat dissipation grooves 13 for receiving the first heat generating element 115 mounted on the back surface of the main board 110 and the second heat generating element 155 mounted on the back surface of the sub-board 150.

In particular, among the heat dissipation grooves 13, the heat dissipation groove 13 for receiving the second heat generating element 155 can be integrally formed in a groove shape within the sub-board receiving groove 133 for receiving the sub-board 150.

In addition, a heat dissipation interface material 20 can be interposed between the inner surfaces of the first heat generating element 115/the second heat generating element 155 and each inner surface of the heat dissipation groove 13. Specific functions of the heat dissipation interface material 20 are described in more detail below.

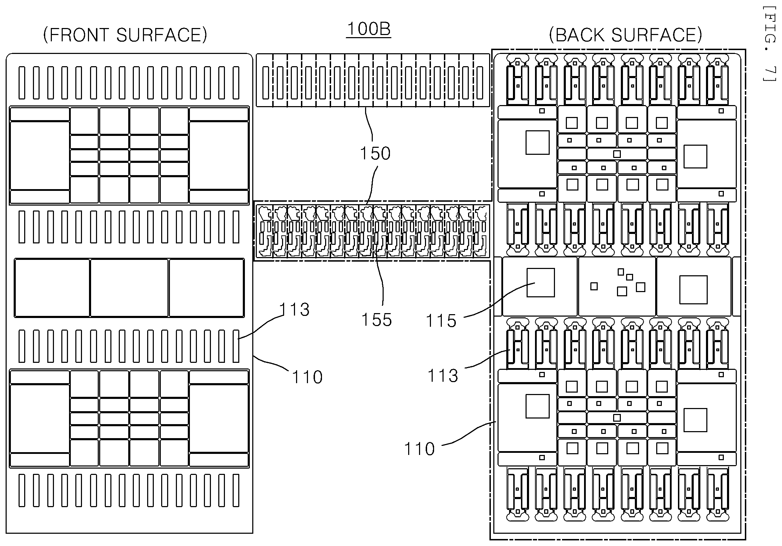

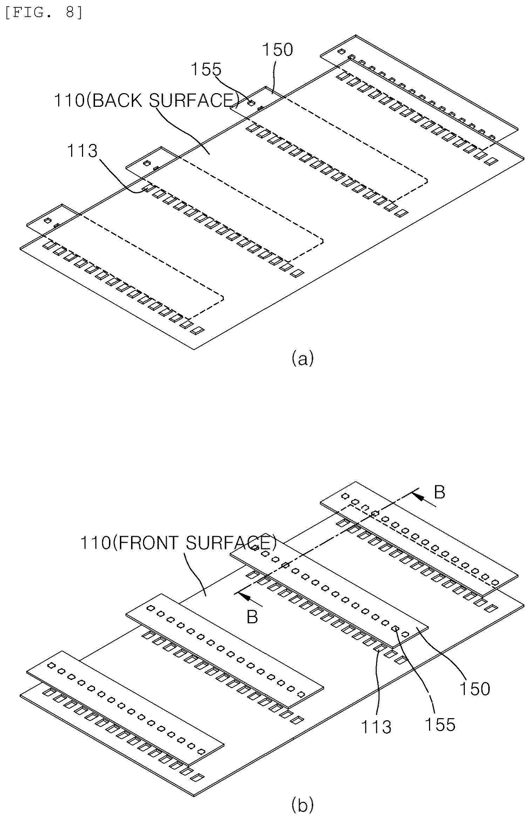

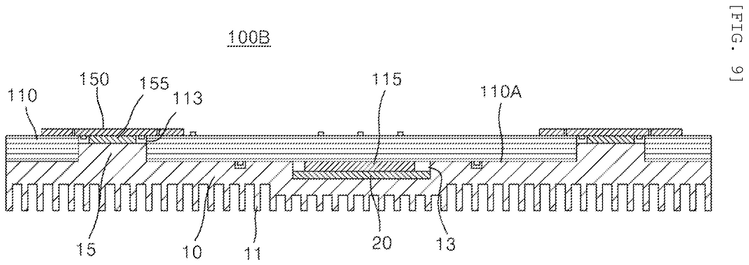

FIG. 7 is a front view and a rear view of a main board and a sub-board implemented as a second embodiment of the present disclosure, FIG. 8 is a front exploded view and a back exploded view of a part of FIG. 7, and FIG. 9 is a cross-sectional view taken along line B-B in FIG. 8.

The arrangement relationship according to the second embodiment 100B is based on the assumption that, as in the first embodiment 100A, the first heat generating element 115 and the second heat generating element 155 are arranged on the same surface as the signal connection surface 115a or 155a and the heat dissipation surface 115b or 155b described above.

More specifically, as illustrated in FIGS. 7 to 9, in the arrangement relationship according to the second embodiment 100B, the main board 110 and the sub-board 150 can be stacked so that the back surface of the sub-board 150 faces the front surface of the main board 110, the signal connection surface 115a or 155a can be provided on the entire back surface of the main board 110 or the sub-board 150, and the first heat generating element 115 and the second heat generating element 155 provided on the back surface thereof with the heat dissipation surface 115b or 155b can be mounted.

Unlike the first embodiment 100A described above, in the second embodiment 100B, the sub-board 150 is arranged on the front surface of the main board 110 instead of the back surface of the main board 110. As illustrated in FIG. 9, a heat dissipation through hole 113 that penetrates forward and backward can be formed in the main board 110 at a portion corresponding to a portion of the sub-board 150 where the second heat generating element 155 is mounted.

This is to ensure that the heat dissipation surface 155b of the second heat generating element 155 mounted on the back surface of the sub-board 150 penetrates and is in surface thermal contact with the inner surface of the mounting space of the heat dissipation housing 10.

In such a case, in the case of the second heat generating element 155, the plurality of signal connection points 155a' formed on the signal connection surface 155a can be connected to corresponding points on the back surface of the main board 110 and the back surface of the sub-board 150 by soldering, and the heat dissipation surface 155b can perform heat dissipation through the heat dissipation housing 10 that is in contact with the heat dissipation through hole 113.

As in the first embodiment 100A described above, on the inner surface of the heat dissipation housing 10, the heat dissipation groove 13 can be formed to receive the first heat generating element 115 mounted on the back surface of the main board 110, and a heat dissipation protrusion 15 can be formed to protrude forward to the heat dissipation surface 155b of the second heat generating element 155 mounted on the back surface of the sub-board 150 exposed to the rear side through the heat dissipation through hole 113 described above.

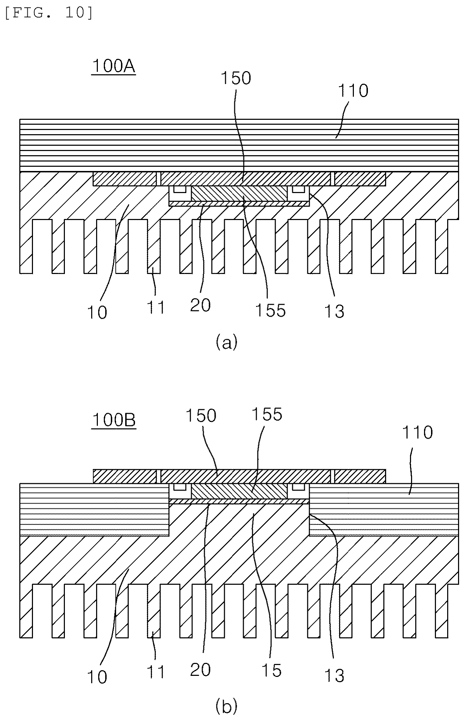

FIG. 10 is a cross-sectional view illustrating a heat dissipation housing adopting a heat dissipation structure of the second heat generating elements according to the first embodiment and the second embodiment, FIG. 11a is a cross-sectional view illustrating a signal connection appearance on a main board, FIG. 11b is a plan perspective view of FIG. 11a, and FIG. 11c is a cross-sectional view and a plan view illustrating a mutual interface of FIG. 11a.

In the arrangement structures according to the first embodiment 100A and the second embodiment 100B, as illustrated in FIG. 9, it can be assumed that the heat dissipation housing 10 uses a surface with which the back surface of the main board 110 is in close contact as a reference plane 110A.

In addition, the heat dissipation housing 10 may include the heat dissipation groove 13 formed by recessing backward based on the reference plane 110A to receive the first heat generating element 115 and the second heat generating element 155 mounted on the back surface of the sub-board 150 stacked on the back surface of the main board 110, the heat dissipation groove 13 being in surface thermal contact with the back surfaces (in particular, the heat dissipation surfaces 115b and 155b) of the first heat generating element 115 and the second heat generating element 155, and the heat dissipation protrusion 15 protruding forward through the heat dissipation through hole 13 based on the reference plane 110A so that the back surface of the second heat generating element 155 mounted on the back surface of the sub-board 150 stacked on the front surface of the main board 110 is in surface thermal contact.

In addition, a heat dissipation interface material 20 can be interposed between the back surface of the first heat generating element 115 or the second heat generating element 155 and the front surface of the heat dissipation groove 13 or the heat dissipation protrusion 15. The heat dissipation interface material 20 can play a role in maximizing heat dissipation performance by eliminating a tolerance existing between the heat dissipation surfaces 115b and 155b of the first heat generating element 115 and the second heat generating element 155 that substantially perform a heat dissipation function and the inner surface of the mounting space of the heat dissipation housing 10 and simultaneously providing a higher heat transfer rate.

Such a heat dissipation interface material 20 may include at least one of thermal grease, a graphite sheet, a heat pipe, a heat spreader, and a vapor chamber.

The electrical connection structure of the main board 110/the sub-board 150 and the second heat generating element 155 of the massive multi-input and multi-output antenna apparatus 1 according to an embodiment of the present disclosure configured as described above is briefly described below with reference to FIGS. 11a to 11c.

First, as illustrated in FIG. 11a, the main board 110 can be provided in a form where multi-layers are joined together, and the conductive pattern 110P1 can be printed between some of the multi-layers for signal connection, and the connection pattern 110P2 printed on the back surface of the main board 110 can be signal-connected to the conductive pattern 110P1 by using the via hole 110V plated with a conductive material.

In addition, as illustrated in FIG. 11a, the sub-board 150 can be provided in the form of a double-sided PCB, each outer layer (front surface and back surface) can be applied or coated with a dielectric layer having a predetermined dielectric constant so that RF characteristics are maintained or optimized mounting is achieved, and a signal connection pattern 150P for signal connection can be configured on each dielectric layer.

In such a case, the second heat generating element 155 is provided on the front surface thereof with the signal connection surface 155a on which the plurality of signal connection points 155a' are formed, so that signal connection is possible by the signal connection pattern 150P formed on the back surface of the sub-board 150 and solder paste during a soldering process. Accordingly, unlike the related art, direct mounting on the back surface of the sub-board 150 is possible.

In addition, as illustrated in FIG. 11a, the electrical signal connection between the main board 110 and the sub-board 150 is made when the connection pattern 110P2 of a predetermined length, which is pattern-printed on the back surface of the main board 110 to be electrically connected to the via hole 110V processed and plated in the thickness direction of the main board 110, comes into contact with the signal connection pattern 150P formed on the back surface of the sub-board 150.

However, in the case where the main board 110 and the sub-board 150 are stacked so that the front surface of the sub-board 150 is in contact with the back surface of the main board 110, when the second heat generating element 155 is mounted on the back surface of the sub-board 150, at least a part of the above-described signal connection pattern 150P needs penetrate the sub-board 150 and be exposed to the front surface for connection with the connection pattern 110P2 of the main board 110. Therefore, processing of a soldering hole 150h as illustrated in FIG. 11a is required, and the connection pattern 110P2 of the main board 110 and the signal connection pattern 150P plated on a part of the inner surface of the soldering hole 150h so as to be exposed to the front surface of the sub-board 150 can be electrically connected by solder 110P.

In particular, referring to FIGS. 11b and 11c, a signal connection structure and an interface are provided to enable an automated soldering process using solder paste, thereby providing the advantage of substantially significantly simplifying the stack process of the sub-board 150 on the main board 110 and the mounting process of the second heat generating element 155 on the sub-board 150 and saving labor costs.

In this way, according to the massive multi-input and multi-output antenna apparatus 1 according to an embodiment of the present disclosure, an area of the sub-board 150 whose manufacturing cost is relatively high can be minimized, the mounting of the second heat generating element 155 on the front surface of the sub-board 150 is unnecessary, and direct mounting on the back surface of the sub-board 150 is possible, so that there is no need to process a configuration such as a heat transfer bridge hole for heat dissipation and the overall product manufacturing cost can be reduced through the simplification of a product manufacturing process.

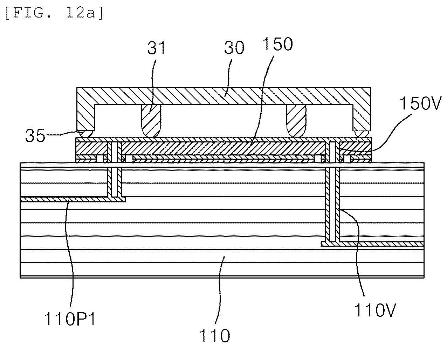

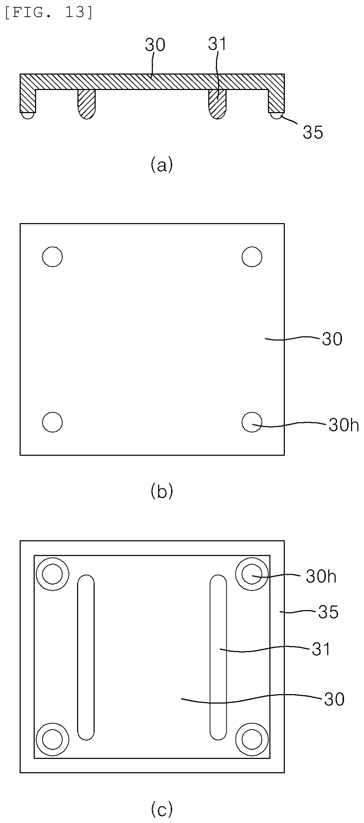

FIGS. 12a to 12c are conceptual views illustrating an electrical connection structure of a sub-board to a main board using a clamshell, FIG. 13 is a three-sided view illustrating the clamshell of FIGS. 12a to 12c, and FIGS. 14 and 15 are conceptual views illustrating embodiments of an electrical connection structure of a sub-board to a main board using an elastic pressing part.

As already described above, as illustrated in FIGS. 11a to 11c, the sub-board 150 with respect to the main board 110 needs go through a necessary process of forming the soldering hole 150h in the sub-board 150 so that the connection pattern 110P2 connected to the via hole 110V formed in the main board 110 is exposed to the outside and then connecting the connection pattern 110P2 of the main board 110 and the signal connection pattern 150P of the sub-board 150 by using the solder 110P, in order to make mutual electrical connections.

However, since the electrical connection structure of the sub-board 150 with respect to the main board 110 as described above is difficult to directly connect to an exposed end of the via hole 110V, a processing process of the soldering hole 150h is absolutely necessary, and since a subsequent soldering process is also essential, the number of processes may increase.

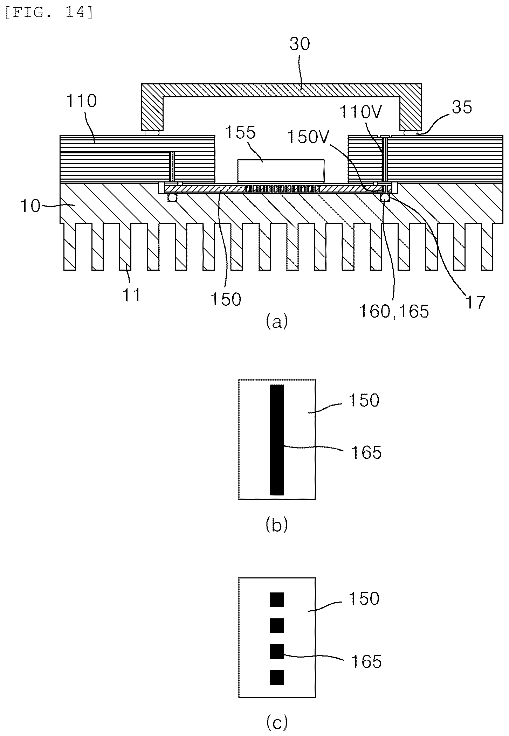

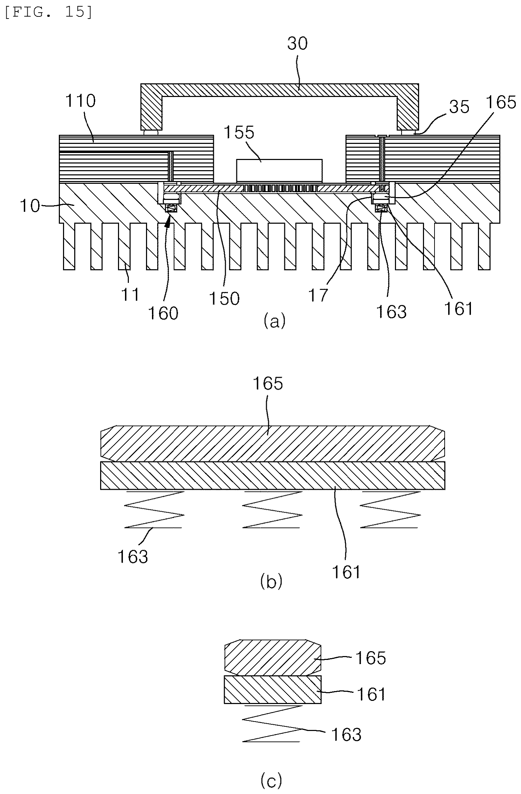

An embodiment of the present disclosure proposes, in order to prevent the addition of the number of processes due to the above-described electrical connection structure, an electrical connection structure in which a clamshell cover 30 is used to press the sub-board 150 in the direction in which the main board 110 is provided according to a first modified example (FIGS. 12a to 12c and 13), or an elastic pressing part 160 is used to press the sub-board 150 in the direction in which the main board 110 is provided according to a second modified example (FIGS. 14 and 15).

The electrical connection structure according to the first modified example relates to the arrangement structure according to the second embodiment 100B of the present disclosure illustrated in FIGS. 7 to 9, and can be limited to when the main board 110 and the sub-board 150 are stacked so that the back surface of the sub-board 150 is in contact with the front surface of the main board 110.

More specifically, as illustrated in FIGS. 12a to 12c and 13, the electrical connection structure according to the first modified example includes the clamshell cover 30 arranged to completely cover the front surface of the sub-board 150 provided so that the back surface is in close contact with the front surface of the main board 110, and having at least one pressing rubber 31 formed on the inner surface to press the sub-board 150 toward the main board 110.

The clamshell cover 30 forms spaces for shielding and receiving electrical components mounted on the outer surfaces of the sub-board 150 and the main board 110 so that a plurality of spaces are defined on one side of the main board 110 including the other surface of the sub-board 150, thereby blocking interference from external signals.

The distal end of the clamshell cover 30 adjacent to the sub-board 150 or main board 110 side can be bonded through an EMI shield rib 35 applied in advance to the sub-board 150 or the main board 110 through the EMI dispensing method.

Referring to FIG. 12a, at least one pressing rubber 31 is made of a rubber material and can be formed on the inner surface of the clamshell cover 30 to be long in a roughly one-sided straight direction, and when the clamshell cover 30 is completely bonded to the sub-board 150 or the main board 110, each distal end of the pressing rubber 31 can be elastically deformed while pressing at least the sub-board 150 in the direction in which the main board 110 is located.

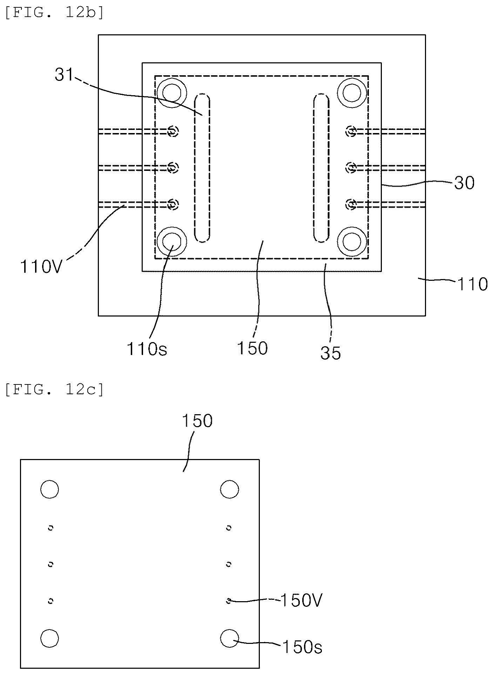

As illustrated in FIGS. 12b and 12c, the bonding of the clamshell cover 30 to the main board 110 and the sub-board 150 can be made by a screw assembly operation through a fixing screw (not illustrated) that is fastened through a screw fastening hole 110s formed in the main board 110 and a screw through hole 150s formed in the sub-board 150.

In this way, as illustrated in FIG. 12a, when the assembly force of the fixing screw is transmitted to the clamshell cover 30, the distal end of the pressing rubber 31 provided inside the clamshell cover 30 elastically supports the other surface (front surface) of the sub-board 150, and the via hole 110V formed in the main board 110 and the via hole 150V formed in the sub-board 150 are directly electrically connected, so that no separate soldering process is required and no soldering process is required for electrical connection between the main board 110 and the sub-board 150, thereby providing the advantage that the processing process of the soldering hole (see reference numeral 150h in FIG. 11a) with respect to the sub-board 150 is also unnecessary.

The electrical connection structure according to the second modified example relates to the arrangement structure according to the first embodiment 100A of the present disclosure illustrated in FIGS. 3 to 6, and may be limited to when the main board 110 and the sub-board 150 are stacked so that the front surface of the sub-board 150 is in contact with the back surface of the main board 110.

However, the case of the arrangement structure of the first embodiment 100A of the present disclosure is limited to the case where the second heat generating element 155 is mounted on the back surface of the sub-board 150; however, it is noted that the electrical connection structure according to the second modified example is limited only to the electrical connection between the main board 110 and the sub-board 150, and thus, as illustrated in FIGS. 14 and 15, it does not exclude the case where the sub-board 150 is stacked on the back surface of the main board 110 and the second heat generating element 155 is mounted on the front surface of the sub-board 150.

More specifically, as illustrated in FIGS. 14 and 15, the electrical connection structure according to the second modified example may include an elastic pressing part 160 that presses the sub-board 150 arranged relatively rearward toward the main board 110 arranged forward.

As illustrated in FIG. 14, the elastic pressing part 160 can be implemented as an elastic rib 165 that is provided to press the sub-board 150 by an elastic force that is one of its own material properties, without a separate elastic means.

In addition, as illustrated in FIG. 15, the elastic pressing part 160 can be implemented in the form of an assembly including an elastic rib 165 arranged on one surface of a support pad 161 and an elastic means 163 provided in the form of a spring to apply an elastic force to the support pad 161 on the other surface of the support pad 161.

More specifically, as illustrated in FIG. 14, a rib installation groove 17 can be provided in the inner surface of the heat dissipation housing 10, and the elastic rib 165 adopted as a component of the elastic pressing part 160 can be inserted and installed.

Therefore, the elastic pressing part 160 can be defined as the elastic rib 165 that is arranged between the inner surface of the heat dissipation housing 10 and the main board 110 and elastically supports the sub-board 150 stacked on the back surface of the main board 110 toward the main board 110.

As illustrated in (a) of FIG. 14, in the state in which the elastic rib 165 is inserted and installed into the rib installation groove 17, when the main board 110 and the sub-board 150 stacked and bonded thereon are stacked and bonded to be in surface-contact with the inner surface of the heat dissipation housing 10, the inner surface of the sub-board 150 is elastically pressed toward the main board 110 by the elastic rib 165 due to the fixing force, and the via hole 110V formed in the main board 110 and the via hole 150V formed in the sub-board 150 are electrically connected (bonded) without requiring a separate soldering process.

The elastic rib 165 can be formed in a straight line shape as illustrated in (b) of FIG. 14, or can be provided in a plural number arranged in a dot shape on a straight line as illustrated in (c) of FIG. 14.

In addition, the elastic rib 165 is illustrated as being arranged only at two locations: one end and the other end of the sub-board 150 in (a) of FIG. 14; however, it is obvious that the elastic rib 165 can also be uniformly arranged at a plurality of locations to provide elastic support over the entire back surface of the sub-board 150.

In addition, as illustrated in (a) of FIG. 15, an assembly installation groove 17a for installing the elastic pressing part 160 provided in the form of an assembly can be formed in the inner surface of the heat dissipation housing 10, and the sub-board 150 can be elastically pressed toward the main board 110 by the elastic rib 165 among the components of the elastic pressing part 160.

As illustrated in (b) and (c) of FIG. 15, the elastic pressing part 160 may include a spring-shaped elastic means 163 interposed inside the assembly installation groove 17a, and a support pad 161 having one surface elastically supported by the elastic means 163 and the other surface having the elastic rib 165 attached thereto.

The elastic means 163 may be limited to a spring. However, the elastic means 163 is not always limited to a spring and it can be understood as a concept including any type of elastic body as long as it uniformly elastically supports the support pad 161.

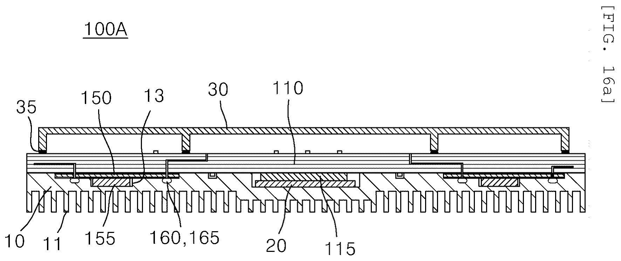

FIGS. 16a to 16d are cross-sectional views illustrating an actual substrate stack structure of an electrical connection structure according to various modified examples of FIGS. 12a to 12c and FIGS. 13 to 15 in a massive multi-input and multi-output antenna apparatus according to an embodiment of the present disclosure.

In the electrical connection structures according to the first and second modified examples described above, the specific application of an embodiment of the present disclosure using the elastic pressing part 160 is described below with reference to FIGS. 16a to 16d.

That is, the massive multi-input and multi-output antenna apparatus 1 according to an embodiment of the present disclosure has a technical feature that, as already described above, the first heat generating element 115 is mounted only on the back surface of the main board 110 and the second heat generating element 155 is mounted only on the back surface of the sub-board 150, and the electrical connection structure described above has a slight structural difference, as illustrated in FIGS. 16a to 16d, but can be flexibly applied.

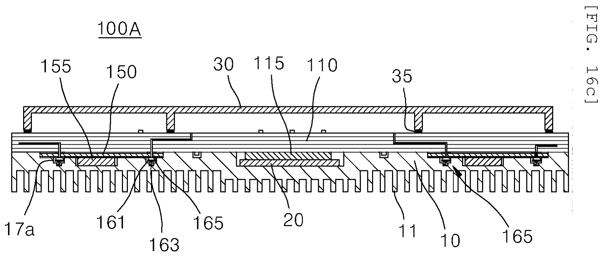

More specifically, as illustrated in FIGS. 16a and 16c, the massive multi-input and multi-output antenna apparatus 100A according to the first embodiment of the present disclosure is applied to a case where the sub-board 150 is stacked on the back surface of the main board 110, and a case where the main board 110 and the sub-board 150 are mounted with the first heat generating element 115 and the second heat generating element 155 in which the signal connection surface 115a or 155a and the heating surface 115b or 155b are formed on different surfaces, respectively.

Referring to FIG. 16a, the sub-board receiving groove 133 for receiving the sub-board 150 and the heat dissipation groove 13 for receiving the second heat generating element 155 mounted to protrude rearward from the back surface of the sub-board 150 can be formed on the inner surface of the heat dissipation housing 10, and the rib installation groove 17 for installing the elastic pressing part 160 provided with only the elastic rib 165 can be formed.

In addition, referring to FIG. 16c, the sub-board receiving groove 133 and the heat dissipation groove 13 can be formed on the inner surface of the heat dissipation housing 10 as in FIG. 16a, and the assembly installation groove 17a for receiving and installing the elastic pressing part 160 provided in the form of an assembly can be formed in a structure similar to the rib installation groove 17 described above.

In this way, in the electrical connection structures of the first modified example and the second modified example applied to the arrangement structure 100A of the massive multi-input and multi-output antenna apparatus 1 according to the first embodiment of the present disclosure, elastic pressure can be applied by a fixing force when the main board 110 and the sub-board 150 are stacked and bonded to the heat dissipation housing 10 (see FIG. 16a), or the elastic rib 165 of the elastic pressing part 160 provided in the form of an assembly can elastically press the sub-board 150 (see FIG. 16c).

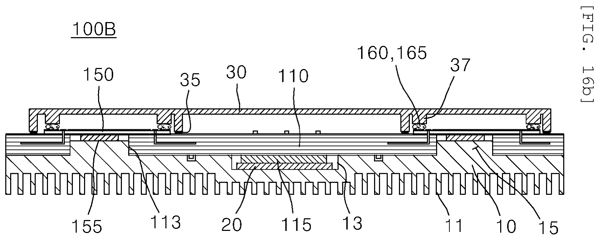

Referring to FIG. 16b, on the inner surface of the heat dissipation housing 10, the heat dissipation protrusion 15 that protrudes forward through the heat dissipation through hole 113 formed in the main board 110, and the heat dissipation groove 13 in which the first heat generating element 115 mounted on the back surface of the main board 110 is received can be formed by groove processing, and the elastic pressing part 160 provided with only the elastic rib 165 can be installed and fixed to the distal end (rear end) of a pressing rib 37 of the clamshell cover 30. In such a case, a configuration similar to the rib installation groove 17 for installing the elastic pressing part 160 can be further provided at the distal end of the pressing rib 37 of the clamshell cover 30; however, it is obvious that it can be differently designed depending on the installation method of the elastic pressing part 160.

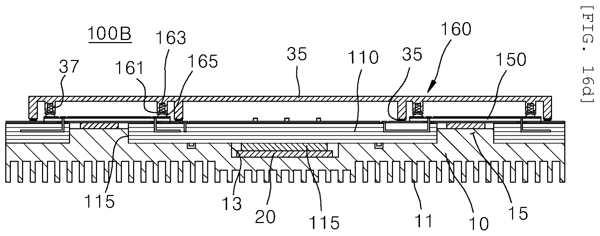

In addition, referring to FIG. 16d, on the inner surface of the heat dissipation housing 10, the heat dissipation protrusion 15 and the heat dissipation groove 13 can be formed as in FIG. 16b, and an assembly installation groove 17a for receiving and installing the elastic pressing part 160 provided in the form of an assembly can be formed on the pressing rib 37 of the clamshell cover 30.

In this way, in the electrical connection structures of the first modified example and the second modified example applied to the arrangement structure 100B of the massive multi-input and multi-output antenna apparatus 1 according to the second embodiment of the present disclosure, in a case where an assembly force is transmitted when the clamshell cover 30 is installed on the heat dissipation housing 10 or the main board 110, the elastic pressing part 160 provided with only the elastic rib 165 can elastically press the sub-board 150 toward the main board 110 (see FIG. 16b), or the elastic rib 165 of the elastic pressing part 160 provided in the form of an assembly can elastically press the sub-board 150 (see FIG. 16d).

Such an implementation of the electrical connection structure of the sub-board 150 with respect to the main board 110 can eliminate the soldering process and the processing process of the sub-board 150 for this as described above, thereby providing the advantage of reducing the number of processes and further improving the reliability of the electrical connection.

In the above, the massive multi-input and multi-output antenna apparatus according to embodiments of the present disclosure have been described in detail with reference to the attached drawings. However, the embodiments of the present disclosure are not necessarily limited to the above-described one embodiment, and it is obvious that various modifications and implementations within an equivalent range are possible by those skilled in the art to which the present disclosure pertains. Therefore, the true scope of the present disclosure is determined by the accompanying claims.

### [Industrial Applicability]

The present disclosure provides a massive multi-input and multi-output antenna apparatus that allows a heat generating element being an RF element to be directly mounted on a back surface of a sub-board and can reduce the overall product manufacturing cost by reducing a separate processing process for heat dissipation.

## Claims

1. A massive multi-input and multi-output antenna apparatus comprising:
a main board stacked so that a back surface of the main board is in close contact with an inner surface of a heat dissipation housing;
a sub board stacked to be in close contact with a front or back surface of the main board;
a first heat generating element mounted only on the back surface of both surfaces of the main board, the back surface being in contact with the inner surface of the heat dissipation housing; and
a second heat generating element mounted only on a back surface of both surfaces of the sub-board, the back surface being in contact with the inner surface of the heat dissipation housing.

2. The massive multi-input and multi-output antenna apparatus of claim 1, wherein the first heat generating element and the second heat generating element are connected to corresponding points formed on the back surfaces of the main board and the sub-board by a brazing method using solder paste applied in advance to surfaces to be mutually joined.

3. The massive multi-input and multi-output antenna apparatus of claim 1, wherein the main board is an integrated single board in which multi-layers stacked in a front and rear direction are integrally joined, and
the sub-board is a double-sided PCB.

4. The massive multi-input and multi-output antenna apparatus of claim 3, wherein the first heat generating element is employed as a digital element capable of controlling a plurality of digital signals by being connected to a plurality of signal contact points implemented through the multi-layers of the main board.

5. The massive multi-input and multi-output antenna apparatus of claim 3, wherein the second heat generating element is employed as an analog element that maintains RF characteristics by a dielectric constant of the double-sided PCB on which dielectric layers having different dielectric constants from the multi-layer of the main board are applied on both surfaces.

6. The massive multi-input and multi-output antenna apparatus of claim 2, wherein the first heat generating element is a digital element, an electrical signal connection surface (hereinafter, abbreviated as 'signal connection surface') provided with a plurality of signal connection points and a heat dissipation surface where operating heat is concentrated and dissipated are separated, the signal connection surface is formed on the front surface mounted in close contact with the back surface of the main board, and the heat dissipation surface is formed on the back surface opposite to the front surface.

7. The massive multi-input and multi-output antenna apparatus of claim 2, wherein the second heat generating element is an analog element, an electrical signal connection surface (hereinafter, abbreviated as 'signal connection surface') provided with a plurality of signal connection points and a heat dissipation surface where operating heat is concentrated and dissipated are separated, the signal connection surface is formed on the front surface mounted in close contact with the back surface of the sub-board, and the heat dissipation surface is formed on the back surface opposite to the front surface.

8. The massive multi-input and multi-output antenna apparatus of claim 6 or 7, wherein corresponding points formed on the main board and the sub-board are formed at positions corresponding to the plurality of signal connection points of the first heat generating element or the second heat generating element.

9. The massive multi-input and multi-output antenna apparatus of claim 1, wherein when the sub-board is arranged on the front surface of the main board, a heat dissipation through hole that penetrates forward and backward is formed in the main board at a portion corresponding to a portion of the sub-board where the second heat generating element is mounted.

10. The massive multi-input and multi-output antenna apparatus of claim 9, wherein when a surface with which the back surface of the main board is in close contact is assumed as a reference plane, the heat dissipation housing is formed with: a heat dissipation groove formed by recessing backward based on the reference plane to receive the first heat generating element and the second heat generating element mounted on the back surface of the sub-board stacked on the back surface of the main board, the heat dissipation groove being in surface thermal contact with the back surfaces of the first heat generating element and the second heat generating element; and a heat dissipation protrusion protruding forward through the heat dissipation through hole based on the reference plane so that the back surface of the second heat generating element mounted on the back surface of the sub-board stacked on the front surface of the main board is in surface thermal contact.

11. The massive multi-input and multi-output antenna apparatus of claim 10, wherein a heat dissipation interface material is interposed between the back surface of the first heat generating element or the second heat generating element and a front surface of the heat dissipation groove or the heat dissipation protrusion.

12. The massive multi-input and multi-output antenna apparatus of claim 11, wherein the heat dissipation interface material includes at least one of thermal grease, a graphite sheet, a heat pipe, a heat spreader, and a vapor chamber.

13. The massive multi-input and multi-output antenna apparatus of claim 1, further comprising:
an elastic pressing part that elastically presses the sub-board toward the main board.
